# EUROPÄISCHE PATENTSCHRIFT

(11) **EP 3 690 468 B1**
(45) Veröffentlichungstag und Bekanntmachung des Hinweises auf die Patenterteilung: **10.01.2024**
(21) Anmeldenummer: 19154206.7
(22) Anmeldetag: 29.01.2019
(51) Int. Cl.: G01R 33/385, G01R 33/561

(54) **MAGNETRESONANZEINRICHTUNG UND VERFAHREN ZUR AUFNAHME VON MAGNETRESONANZDATEN MIT EINER GRADIENTENSPULE WELCHE ZUR ERZEUGUNG EINES RADIALEN GRADIENTENFELDS AUSGEBILDET IST**
MAGNETIC RESONANCE DEVICE AND METHOD FOR RECORDING OF MAGNETIC RESONANCE DATA WITH A GRADIENT COIL THAT IS CONFIGURED TO GENERATE A RADIAL GRADIENT FIELD
DISPOSITIF DE RÉSONANCE MAGNÉTIQUE ET PROCÉDÉ D'ENREGISTREMENT DES DONNÉES DE RÉSONANCE MAGNÉTIQUE AU MOYEN D'UNE BOBINE DE GRADIENT CONÇU POUR GÉNÉRER UN CHAMP DE GRADIENT RADIAL

(43) Veröffentlichungstag der Anmeldung: 05.08.2020
(73) Patentinhaber: Siemens Healthcare GmbH, 91052 Erlangen (DE)
(72) Erfinder: Dewdney, Andrew, 91077 Neunkirchen am Brand (DE); Dietz, Peter, 90762 Fürth (DE)
(74) Vertreter: Siemens Healthineers Patent Attorneys

(56) Entgegenhaltungen:
- LEE S Y ET AL: "LOCALIZED VOLUME SELECTION TECHNIQUE USING AN ADDITIONAL RADIAL GRADIENT COIL", MAGNETIC RESONANCE IN MEDICINE, JOHN WILEY & SONS, INC, US, Bd. 12, Nr. 1, 1. Oktober 1989 (1989-10-01), Seiten 56-63, XP000081155, ISSN: 0740-3194
- JASON P. STOCKMANN ET AL: "O-space imaging: Highly efficient parallel imaging using second-order nonlinear fields as encoding gradients with no phase encoding", MAGNETIC RESONANCE IN MEDICINE., 1. Januar 2010 (2010-01-01), Seiten 447-456, XP055251426, US ISSN: 0740-3194, DOI: 10.1002/mrm.22425
- LEE D H ET AL: "MRI in cylindrical coordinates", MAGNETIC RESONANCE IMAGING, ELSEVIER SCIENCE, TARRYTOWN, NY, US, Bd. 12, Nr. 4, 1. Januar 1994 (1994-01-01) , Seiten 613-620, XP026310462, ISSN: 0730-725X, DOI: 10.1016/0730-725X(94)92456-2 [gefunden am 1994-01-01]

## Beschreibung

Die Erfindung betrifft eine Magnetresonanzeinrichtung, aufweisend eine Hauptmagneteinheit mit einer zylindrischen Patientenaufnahme. Daneben betrifft die Erfindung ein Verfahren zur Aufnahme von Magnetresonanzdaten mit einer solchen Magnetresonanzeinrichtung.

Die Magnetresonanzbildgebung ist ein inzwischen etabliertes Werkzeug, insbesondere im medizinischen Sektor, wenn Magnetresonanzbilder eines Patienten aufgenommen werden sollen. Magnetresonanzeinrichtungen weisen dabei üblicherweise eine Hauptmagneteinheit auf, die den Grundfeldmagneten enthält und eine Patientenaufnahme ("Bore") aufweist, in welche der Patient, insbesondere mittels einer Patientenliege, eingefahren werden kann. Innerhalb der Patientenaufnahme befindet sich das Sichtfeld (Field of View) der Magnetresonanzeinrichtung, also das Homogenitätsvolumen, in welchem die Homogenität des Grundmagnetfeldes gut genug ist, um sinnvoll Bildgebung betreiben zu können. Der zentrale Bereich dieses Sichtfelds/Homogenitätsvolumen wird dabei oft auch als Isozentrum der Magnetresonanzeinrichtung bezeichnet, welches sich um das Zentrum der Patientenaufnahme erstreckt.

Zur Ortskodierung werden der Magnetresonanzbildgebung dem Grundmagnetfeld Gradientenfelder überlagert, welche durch Gradientenspulen erzeugt werden. Bekannte Magnetresonanzeinrichtungen nutzen hierbei eine Gradientenspulenanordnung, die beispielsweise im Inneren der Patientenaufnahme, diese umgebend, angeordnet sein kann, welche Gradientenspulen für verschiedene Richtungen eines kartesischen Koordinatensystems aufweist, üblicherweise für die Z-Richtung als Längsrichtung der zylindrischen Patientenaufnahme bzw. die Richtung, in der das Grundmagnetfeld orientiert ist, die X-Richtung als dazu senkrechte horizontale Richtung und die Y-Richtung als hierzu senkrechte vertikale Richtung. Diese Gradientenspulen erzeugen dabei lineare Gradienten.

In letzter Zeit wurden vermehrt Ansätze vorgeschlagen, um auch nicht lineare bzw. lokale Gradientenfelder einzusetzen, was beispielsweise unter den Stichworten "PATLOC - Parallel Imaging Technique Using Localized Gradients" oder "FRONSAC - Fast Rotary Nonlinear Spatial Acquisition" bekannt wurde. Rein beispielhaft sei auf den Artikel von Jürgen Hennig et al. "Parallel imaging in non-bijective, curvilinear magnetic field gradients: a concept study", Magn Reson Mater Phy 21 (2008), Seiten 5 - 14, und den Artikel von Haifeng Wang et al. "Fast Rotary Nonlinear Spatial Acquisition (FRONSAC) Imaging", Magn Reson Med 75 (2016), 1154 - 1165, verwiesen.

Diese Gradientenvarianten wurden dabei hauptsächlich im Kontext mit paralleler Bildgebung (PAT - Parallel Acquisition Technique) vorgeschlagen, also bei Verwendung von Hochfrequenzspulenanordnungen, welche unabhängig zum Senden und/oder Empfangen betreibbare bzw. ansteuerbare Hochfrequenzspulenelemente aufweisen. Unter Nutzung nichtlinearer und/oder lokaler Gradienten soll eine Beschleunigung und/oder Verbesserung der Magnetresonanzbildgebung ermöglicht werden, indem die Bildgebung in verschiedenen Arealen parallelisiert wird.

Zur Realisierung solcher nichtlinearer Gradientenfelder wurde im Stand der Technik vorgeschlagen, Feldverteilungen in Form von Kugelfunktionen zweiter Ordnung zu verwenden, beispielsweise Gradientenfelder in Form des A20-Feldanteils. Derartige Feldanteile zweiter Ordnung werden im Stand der Technik auch im Hinblick auf Shimspulen genutzt, wobei Shimspulen für verschiedene Feldanteile (A20, A21, A22, B21, B22, ...) beispielhaft genannt seien. Mit derartigen Shimspulen können beispielsweise entsprechende Anteile von Störfeldern kompensiert werden.

Feldverteilungen zweiter Ordnung, insbesondere gemäß Kugelfunktionen zweiter Ordnung, mögen einfach durch lokale Gradientenspulen umsetzbar sein, weisen jedoch den Nachteil auf, dass im Bereich des Isozentrums, also nahe an der beispielsweise benachbart zu einem Hochfrequenzspulenelement angeordneten Gradientenspule, aufgrund des polynomialen Verlaufs nur geringe Steigungen zu erwarten sind, so dass im beschriebenen Beispiel in dem Bereich, in dem die Hochfrequenzspulenelemente am empfindlichsten sind, keine oder eine nur unzureichenden Ortsauflösung aufgrund der Gradientenfelder möglich ist. Mit anderen Worten können sich Stellen im Zentrum des Sichtfelds ergeben, in denen eine Ortsauflösung nicht oder nicht hinreichend gut möglich ist.

LEE S Y ET AL: "LOCALIZED VOLUME SELECTION TECHNIQUE USING AN ADDITIONAL RADIAL GRADIENT COIL", MAGNETIC RESONANCE IN MEDICINE, JOHN WILEY & SONS, INC, US, Bd. 12, Nr. 1, 1. Oktober 1989 (1989-10-01), Seiten 56-63, beschreibt ein Verfahren zur Verwendung einer radialen Gradientenspule für die Wahl eines Volumens. JASON P. STOCKMANN ET AL: "O-space imaging: Highly efficient parallel imaging using second-order nonlinear fields as encoding gradients with no phase encoding", MAGNETIC RESONANCE IN MEDICINE., 1. Januar 2010 (2010-01-01), Seiten 447-456, beschreibt ein Verfahren zur parallelen Bildgebung unter Verwendung nichtlinearer Kodierungsgradienten. LEE D H ET AL: "MRI in cylindrical coordinates", MAGNETIC RESONANCE IMAGING, ELSEVIER SCIENCE, TARRYTOWN, NY, US, Bd. 12, Nr. 4, 1. Januar 1994 (1994-01-01), Seiten 613-620, beschreibt ein Verfahren zur eindimensionalen MR-Bildgebung unter Verwendung zylindrischer Koordinaten.

Der Erfindung liegt die Aufgabe zugrunde, eine verbesserte, insbesondere intuitiv zur Geometrie bei der Magnetresonanzbildgebung und/oder eines aufzunehmenden Patienten passende, einfach umzusetzende Möglichkeit zur Erzeugung eines bei der Aufnahme von Magnetresonanzdaten zu nutzenden nichtlinearen Gradientenfeldes anzugeben.

Zur Lösung dieser Aufgabe sind erfindungsgemäß eine Magnetresonanzeinrichtung und ein Verfahren zur Aufnahme von Magnetresonanzdaten mit einer Magnetresonanzeinrichtung gemäß den unabhängigen Ansprüchen vorgesehen. Vorteilhafte Ausgestaltungen ergeben sich aus den Unteransprüchen.

Eine erfindungsgemäße Magnetresonanzeinrichtung, aufweisend eine Hauptmagneteinheit mit einer zylindrischen Patientenaufnahme, weist in der Patientenaufnahme wenigstens eine als Zylinderspule ausgebildete Radialgradientenspule auf, welche zur Erzeugung eines zumindest bereichsweise einen radialen Gradienten bezüglich der eigenen, zur Längsachse der Patientenaufnahme parallelen Mittelachse aufweisenden Gradientenfeldes ausgebildet ist. Erfindungsgemäß ist zusätzlich zu der Radialgradientenspule eine A20-Gradientenspule als Teil der Magnetresonanzeinrichtung vorgesehen, wobei eine Steuereinrichtung der Magnetresonanzeinrichtung zur ergänzenden Nutzung der Radialgradientenspule und der A20-Gradientenspule zur Realisierung einer Ortskodierung ausgebildet ist.

Die vorliegende Erfindung bezieht sich mithin auf Magnetresonanzeinrichtungen mit einer zylindrischen, in einer Hauptmagneteinheit ausgebildeten Patientenaufnahme. Die Hauptmagneteinheit enthält den üblicherweise supraleitenden Grundfeldmagneten, dessen Grundmagnetfeld entlang der Längsrichtung (Z-Richtung) der zylindrischen Patientenaufnahme orientiert ist.

Es wird nun vorgeschlagen, eine Radialgradientenspule zu verwenden, welche ein Gradientenfeld mit einem radialen Gradienten erzeugt. Hierzu ist die Radialgradientenspule zweckmäßigerweise als Zylinderspule ausgebildet und mit ihrer Mittelachse parallel zur Patientenaufnahme ausgerichtet. Eine einen radialen Gradienten aufweisende Feldverteilung lässt sich keinem einzelnen Term der üblicherweise zur Feldbeschreibung verwendeten Kugelfunktionen zuteilen, weist jedoch interessante Eigenschaften auf. Zunächst ist festzuhalten, dass die Radialrichtung eine Grundrichtung eines zylindrischen oder Kugel-Koordinatensystems ist. Auch die Patientenaufnahme ist üblicherweise ja zylindrisch ausgebildet. Ein weiterer, deutlicher Vorteil eines radial verlaufenden Gradienten ist, dass nahe an der Radialgradientenspule, mithin im Bereich des Isozentrums der Magnetresonanzeinrichtung, gerade die stärkeren Feldunterschiede, mithin ein starker Gradient, vorliegen.

Ein radialer Verlauf eines Gradienten lässt sich durch eine Zylinderspule realisieren, deren Mittelachse der Längsachse der Patientenaufnahme entspricht bzw. parallel zu dieser verläuft. Außerhalb des Wicklungsquerschnitts der Zylinderspule der relativ klein sein kann, wird das erzeugte Gradientenfeld dann abhängig vom Abstand von der Radialgradientenspule abnehmen und somit eine zumindest annähernd radiale Feldverteilung erzeugen.

Zusammenfassend ist eine eine radiale oder annähernd radiale Feldverteilung als "Zusatzgradient" erzeugende Radialgradientenspule alternativ oder zusätzlich zu weiteren Gradientenspulen geeignet, um die Parallelisierung der Magnetresonanzdatenaufnahme zu verbessern, da der bei bisherigen Ansätzen von starken Gradienten freie Raum im Isozentrum, also Zentrum des Sichtfelds, mit starken Gradienten gefüllt wird. Zudem gilt bei mittiger Platzierung bezüglich eines Patienten, dass die Feldcharakteristik des Gradientenfelds der Radialgradientenspule gut mit der des Körpers korreliert. Denn ein Patient weist eher angenähert zylindrische Formen als "kartesische" Formen auf, so dass eine der Körperform angemessene Feldverteilung realisiert wird. Damit ist eine hervorragende Basis für zukünftige entsprechende Anwendungen gegeben.

Die Windungen der Radialgradientenspule können beispielsweise aus Kupfer bestehen. Zweckmäßigerweise kann der Windungsradius der Radialgradientenspule in einem Bereich von 1 cm bis 10 cm liegen, beispielsweise bei 5 cm, und/oder die Radialgradientenspule kann sich in Längsrichtung entlang wenigstens der Länge des Sichtfelds der Magnetresonanzeinrichtung erstrecken, insbesondere bei Länge von wenigstens 50 cm. Nachdem die insbesondere aus Kupfer bestehende Leitung, die zu den Wicklungen zu den Radialgradientenspule geformt ist, den zur Erzeugung hinreichend starker Gradientenfelder nötigen Gradientenstrom tragen können muss, sind die inneren Radien je nach Auslegung begrenzt. Als eine geeignete Größe hat sich beispielsweise ein Windungsradius im Bereich von 2,5 bis 5 cm erwiesen, da für eine Zylinderspule entsprechenden Durchmessers dann auch mit Sicherheit der benötigte Raum innerhalb der Patientenaufnahme zur Verfügung steht. Die Radialgradientenspule kann in Längsrichtung bevorzugt länger als die Länge des Sichtfeldes der Magnetresonanzeinrichtung sein, da dann auch Bewegungen der Radialgradientenspule innerhalb der Patientenaufnahme, beispielsweise gemeinsam mit der Patientenliege, nicht dazu führen, dass die Radialgradientenspule (vollständig) aus dem Sichtfeld der Magnetresonanzeinrichtung, mithin aus dem Homogenitätsvolumen, entfernt wird. Beispielsweise kann vorgesehen sein, dass sich die Radialgradientenspule wenigstens über die Hälfte der Länge der Patientenaufnahme erstreckt.

In einer ersten alternativen Ausbildung kann die Mittelachse der Radialgradientenspule der Längsachse der Patientenaufnahme entsprechen. Diese Ausgestaltung ist insbesondere dann vorteilhaft umsetzbar, wenn eine große, mithin einen hohen Durchmesser aufweisende Patientenaufnahme gegeben ist, so dass beispielsweise eine Patientenliege mittig platziert werden kann und somit die Radialgradientenspule beispielsweise in die Patientenliege integriert bzw. auf, in oder unter dieser angeordnet genau auf der Längsachse der Patientenaufnahme liegen kann. Dann wird durch den radialen Gradienten im Wesentlichen unmittelbar ein einem Zylinderkoordinatensystem der Patientenaufnahme hinsichtlich des Radius entsprechendes Anordnungsprinzip realisiert.

Insbesondere dann, wenn der Durchmesser der Patientenaufnahme eher kleiner ist, ist es im Rahmen der vorliegenden Erfindung in einer zweiten Alternative jedoch auch denkbar, dass die Mittelachse der Radialgradientenspule gegen die Längsachse der Patientenaufnahme verschoben ist, insbesondere in vertikaler Richtung. In dieser Ausgestaltung ist die Zylinderspule also insbesondere gegenüber der Längsachse der Patientenaufnahme abgesenkt positioniert, so dass die erzeugten Gradientenfelder nicht mehr allein von der Radiusposition innerhalb der Patientenaufnahme abhängig sind, sondern sowohl vom Radius als auch von der Umfangsposition. Das Gradientenfeld weist somit auch eine bekannte und wohldefinierte Umfangskomponente auf, was in der Bildrekonstruktion entsprechend zu berücksichtigen ist. Dies ist aber problemlos möglich, nachdem im Stand der Technik bereits Verarbeitungsvarianten für deutlich komplexere Gradientenfeldverteilungen bereits vorgeschlagen wurden.

Mit besonderem Vorteil kann in weiterer Ausgestaltung der vorliegenden Erfindung vorgesehen sein, dass zusätzlich zu der Radialgradientenspule und der A20-Gradientenspule eine Gradientenspulen für Richtungen eines kartesischen Koordinatensystems umfassende Gradientenspulenanordnung als Teil der Magnetresonanzeinrichtung vorgesehen ist, wobei eine Steuereinrichtung der Magnetresonanzeinrichtung zur ergänzenden Nutzung der Radialgradientenspule und der Gradientenspulenanordnung ausgebildet ist, insbesondere zur Realisierung einer Ortskodierung.

Ein zumindest näherungsweise radial verlaufender Gradient lässt sich besonders vorteilhaft mit einer A20-Feldverteilung ergänzen, da die A20-Feldverteilung in der zur Längsrichtung der Patientenaufnahme senkrechten Ebene (X-Y-Ebene) konstante Werte aufweist und in der Längsrichtung variiert, während sich eine radiale Feldverteilung genau invers verhält: konstant in der Längsrichtung der Patientenaufnahme und stark variierend mit dem Abstand von der Längsachse der Patientenaufnahme. Mithin lassen sich bekannte und wohldefinierte, unterschiedliche Kodierungsrichtungen abdeckende Gradientenfelder mithilfe der Radialgradientenspule und der A20-Gradientenspule erzeugen, wobei sich aus dem bekannten Feldverlauf in der Steuereinrichtung der Magnetresonanzeinrichtung, gegebenenfalls unter zusätzlicher Beachtung eines aufnehmenden Hochfrequenzspulenelements einer Hochfrequenzspulenanordnung, eine entsprechende räumliche Position zuordnen lässt, so dass eine Ortskodierung gegeben ist.

Im Zusammenhang mit einer heute üblicherweise gängigen "kartesischen" Gradientenspulenanordnung, also einer solchen, die Gradientenspulen für die X-, Y- und Z-Richtung, welche der Längsrichtung der Patientenaufnahme entspricht, aufweist, lässt sich besonders vorteilhaft ein zylindrisches Koordinatensystem umsetzen, in dem die Radialgradientenspule gemeinsam mit der Z-Gradientenspule der Gradientenspulenanordnung betrieben wird. Ein derartiges zylindrisches Koordinatensystem, in dem die Längsrichtung der Patientenaufnahme durch das Gradientenfeld der Z-Gradientenspule abgedeckt wird, die Radialrichtung durch die Radialgradientenspule, ist besonders geeignet für die Bildgebung an in Zylinderform annäherbaren Patienten, beispielsweise im Torso-Bereich. Insbesondere ist zu beachten, dass für viele Anwendungsfälle der Magnetresonanzbildgebung bereits vorgeschlagen wurde, Lokalspulen als Hochfrequenzspulenanordnung zu verwenden, deren Hochfrequenzspulenelemente auf der Körperoberfläche den entsprechend aufzunehmenden Körperteil des Patienten umgebend angeordnet werden, mithin die Anordnung der Hochfrequenzspulenelemente selbst einer zumindest angenäherten Zylinderform folgt.

Die Magnetresonanzeinrichtung kann eine in die Patientenaufnahme einfahrbare Patientenliege aufweisen, wobei vorzugsweise die Radialgradientenspule in die Patientenliege integriert oder auf oder in der Patientenliege, insbesondere unter Verwendung einer Radialgradientenspulenaufnahme platziert oder unterhalb der Patientenliege angeordnet ist. Dabei sind auch Ausgestaltungen denkbar, insbesondere wenn der Durchmesser der Patientenaufnahme hinreichend groß ist, in denen die Patientenliege mittig platziert werden kann, so dass insbesondere möglich ist, die Radialgradientenspule mit ihrer Mittelachse auf der Längsachse der Patientenaufnahme zu platzieren. Dabei kann eine vollständige Integration der Radialgradientenspule in die Patientenliege vorgesehen sein. Möglich ist es aber auch, eine Radialgradientenspulenaufnahme vorzusehen, die die Radialgradientenspule, gegebenenfalls nur bei Bedarf, aufnimmt. Insbesondere dann, wenn kleinere Patientenaufnahmen oder Probleme bezüglich der Ausdehnung der Patientenliege gegeben sind, kann es auch besonders zweckmäßig sein, die Radialgradientenspule unterhalb der Patientenliege anzuordnen, insgesamt mithin vertikal versetzt gegenüber der Längsachse der Patientenaufnahme. Die Integration in bzw. Platzierung/Befestigung in, auf oder unter der Patientenliege hat den Vorteil, dass Zuleitungen zu der Radialgradientenspule gemeinsam mit anderen, gegebenenfalls vorgesehenen Zuleitungen zu der Patientenliege kombiniert realisiert sein können, wobei insbesondere bei nur zeitweise, auf, in oder unter der Patientenliege platzierbarer bzw. befestigbarer Radialgradientenspule auch ein Steckplatz oder dergleichen zum Anschluss der Radialgradientenspule in der Patientenliege realisiert sein kann.

Zweckmäßigerweise kann der Radialgradientenspule wenigstens ein Isolationsmittel zur Wärme- und/oder elektrischen Isolation gegenüber einem Patienten zugeordnet sein. Beispielsweise kann bei einer auf und/oder in einer Patientenliege platzierbaren Radialgradientenspule diese von einem elektrischen Isolationsmittel umgeben sein, welches bevorzugt auch wärmeisolierend wirkt. Bei einer Anordnung unterhalb der Patientenliege wirkt die Patientenliege selbst mit als Isolationsmittel. Auf diese Weise können elektrische und Wärmeeffekte bezüglich des Patienten, die negativ auf diesen wirken könnten, vermieden werden.

In diesem Kontext sieht eine vorteilhafte Weiterbildung der vorliegenden Erfindung zudem vor, dass der Radialgradientenspule eine Kühleinrichtung zugeordnet ist. Während derartige Kühleinrichtungen für Radialgradientenspulen grundsätzlich im Stand der Technik bereits bekannt sein mögen, bieten sich vorliegend spezielle Ausgestaltungen an, die eine möglichst geringe Störung der Bildgebung mit der Magnetresonanzeinrichtung aufgrund der zentralen Anordnung (im oder nahe am Sichtfeld) von Kühlkanälen für das Kühlmedium ermöglichen. Nachdem Magnetresonanzeinrichtungen üblicherweise auf die Detektion von Wasser hin ausgerichtet sind, sieht eine erste vorteilhafte Ausgestaltung der vorliegenden Erfindung in dieser Hinsicht vor, dass die Kühleinrichtung mit einem nicht Wasser entsprechenden Kühlmittel, insbesondere einem Öl, betrieben wird. Auf diese Weise kann vermieden werden, dass aufgrund des Kühlmittels Störungen entstehen, insbesondere durch Aufnahme von Magnetresonanzsignalen des Kühlmittels. Eine weitere, besonders vorteilhafte Ausgestaltung der Erfindung sieht diesbezüglich vor, dass die Kühleinrichtung wenigstens einen innerhalb eines Spulenleiters der Radialgradientenspule verlaufenden Kühlkanal für das Kühlmittel aufweist. Beispielsweise können die Wicklungen der Radialgradientenspule mithin aus einem hohlen Spulenleiter, beispielsweise als Kupferrohre, ausgebildet sein, in denen das Kühlmittel, welches dann auch Wasser sein kann, abgeschirmt von jeglichen Bildgebungsvorgängen zirkuliert.

Wie bereits dargelegt wurde, wird die Radialgradientenspule insbesondere zur Beschleunigung und/oder Verbesserung paralleler Bildgebungsvorgänge eingesetzt, so dass die Magnetresonanzeinrichtung bevorzugt auch eine zur parallelen Bildgebung ausgebildete Hochfrequenzspulenanordnung aufweisen kann. Diese weist mithin mehrere Hochfrequenzspulenelemente auf, die unabhängig voneinander, also im Parallelbetrieb, senden und/oder empfangen können, insbesondere also unabhängig durch die Steuereinrichtung ansteuerbar sind. Die bereits erwähnte Steuereinrichtung kann mithin zur parallelen Bildgebung mit der Magnetresonanzeinrichtung unter Nutzung der Hochfrequenzspulenanordnung und wenigstens der Radialgradientenspule zur Ortskodierung ausgebildet sein.

Neben der Magnetresonanzeinrichtung betrifft die Erfindung auch ein Verfahren zur Aufnahme von Magnetresonanzdaten mit einer erfindungsgemäßen Magnetresonanzeinrichtung. Dabei ist vorgesehen, dass, insbesondere gesteuert von einer Steuereinrichtung, eine parallele Bildgebungstechnik mit einer Hochfrequenzspulenanordnung mit mehreren Hochfrequenzspulenelementen verwendet wird und zur Erzeugung von zur Ortskodierung empfangener Magnetresonanzsignale wenigstens eines Hochfrequenzspulenelements zu verwendender Gradientenfelder wenigstens die Radialgradientenspule und die A20-Gradientenspule verwendet wird. Sämtliche Ausführungen bezüglich der erfindungsgemäßen Magnetresonanzeinrichtung lassen sich analog auf das erfindungsgemäße Verfahren übertragen, so dass mit diesen die bereits genannten Vorteile erhalten werden können.

Insbesondere kann mithin auch im Rahmen des erfindungsgemäßen Verfahrens vorgesehen sein, dass zusätzlich zu der Radialgradientenspule zur Ortskodierung auch eine Gradientenspulen für Richtungen eines kartesischen Koordinatensystems umfassende Gradientenspulenanordnung verwendet wird. Beispielsweise ist es dann möglich, dass durch gemeinsame Nutzung der Radialgradientenspule und einer einen linearen Gradienten entlang der Längsrichtung erzeugenden Gradientenspule der Gradientenspulenanordnung eine Zylinderkoordinaten-Ortskodierung erzeugt wird.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine Magnetresonanzeinrichtung gemäß einem ersten Ausführungsbeispiel der vorliegenden Erfindung,
- Fig. 2: einen Querschnitt durch die Patientenaufnahme der Magnetresonanzeinrichtung gemäß Fig. 1,
- Fig. 3: einen Längsschnitt durch die Patientenaufnahme der Magnetresonanzeinrichtung gemäß Fig. 1,
- Fig. 4: eine mögliche Ausgestaltung eines Spulenleiters,
- Fig. 5: einen Querschnitt durch die Patientenaufnahme bei einem zweiten Ausführungsbeispiel einer erfindungsgemäßen Magnetresonanzeinrichtung, und
- Fig. 6: eine Ausgestaltung einer Patientenliege im zweiten Ausführungsbeispiel.

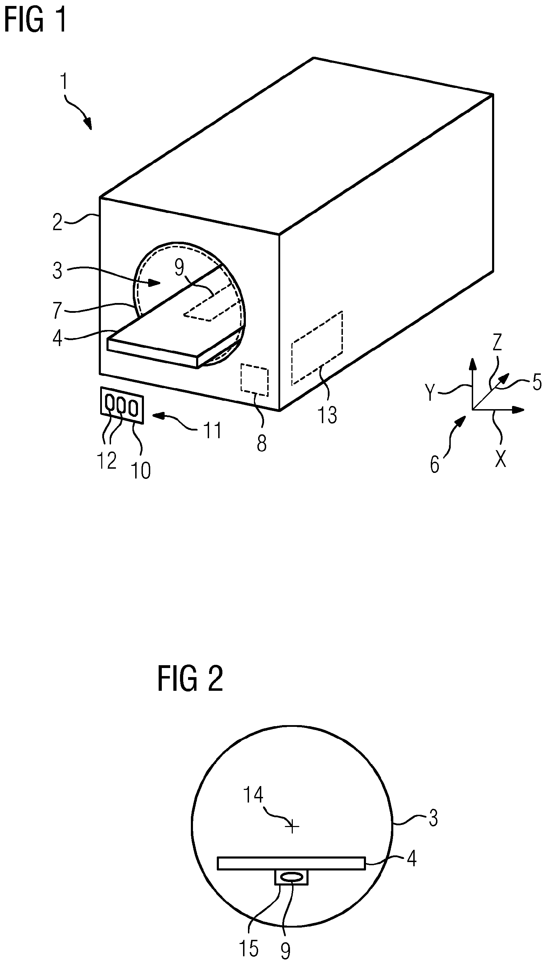

Fig. 1 zeigt eine schematische Ansicht eines ersten Ausführungsbeispiels einer erfindungsgemäßen Magnetresonanzeinrichtung 1. Diese weist, wie grundsätzlich bekannt, eine Hauptmagneteinheit 2 auf, in der eine zylindrische Patientenaufnahme 3 ausgebildet ist. In die Patientenaufnahme 3 kann ein Patient mittels einer Patientenliege 4 eingefahren werden. Die Längsrichtung 5 der Patientenaufnahme 3 entspricht dabei vorliegend der Z-Richtung eines verwendeten kartesischen Koordinatensystems 6. Für jede der Richtungen des kartesischen Koordinatensystems 6 umfasst eine die Patientenaufnahme 3 umgebend angeordnete Gradientenspulenanordnung 7 eine hier nicht näher gezeigte Gradientenspule, so dass mithin eine Gradientenspule für die X-Richtung, eine Gradientenspule für die Y-Richtung und eine Gradientenspule für die Z-Richtung vorgesehen sind.

Die Magnetresonanzeinrichtung 1 umfasst ferner auch eine A20-Gradientenspule 8, mithin eine Gradientenspule, die ein Gradientenfeld erzeugen kann, welches in seiner Feldverteilung dem A20-Term der Lösung der Laplace-Gleichung in Kugelkoordinaten entspricht, mithin der entsprechend enthaltenen Kugelflächenfunktion nachgebildet ist. Die A20-Feldverteilung zeichnet sich insbesondere dadurch aus, dass sie in der X-Y-Ebene, vgl. Koordinatensystem 6, konstante Werte aufweist und in Z-Richtung, also Längsrichtung 5, variiert. Die hier nur angedeutete A20-Gradientenspule 8 kann als Teil der Gradientenspulenanordnung 7 realisiert sein, aber auch als getrenntes Bauteil vorliegen oder sogar in, an oder auf der Patientenliege 4 realisiert bzw. platziert sein. Nachdem derartige A20-Gradientenspulen im Stand der Technik bereits vorgeschlagen wurden, soll diese hier nicht näher diskutiert werden.

Die Magnetresonanzeinrichtung 1 umfasst ferner eine Radialgradientenspule 9, die vorliegend unterhalb der Patientenliege 4 angeordnet ist und entsprechend in Fig. 1 nur gestrichelt angedeutet ist. Die Radialgradientenspule 9 ist als Zylinderspule ausgebildet, deren Mittelachse parallel zur Längsachse der Patientenaufnahme 3 verläuft, mithin in Längsrichtung 5 liegt.

Fig. 1 zeigt ferner eine vorliegend als Lokalspule 10 ausgebildete Hochfrequenzspulenanordnung 11 mit mehreren Spulenelementen 12, die beispielsweise auf dem Patienten platziert werden kann. Die Hochfrequenzspulenanordnung 11 ermöglicht eine parallele Bildgebung. Die Magnetresonanzeinrichtung 1 kann auch weitere Hochfrequenzspulenanordnungen 11 aufweisen, beispielsweise nach innen an die Gradientenspulenanordnung 7 anschließend, die Patientenaufnahme 3 umgebend als Ganzkörperspule bzw. Ganzkörperspulenanordnung (Bodycoil).

Zur Aufnahme von Magnetresonanzdaten werden die verschiedenen Komponenten der Magnetresonanzeinrichtung 1 durch eine Steuereinrichtung 13 angesteuert. Dieses ist vorliegend insbesondere ausgebildet, auch die Radialgradientenspule 9 zur Ortskodierung zu nutzen, insbesondere bei einem parallelen Bildgebungsvorgang.

Dabei wird die Radialgradientenspule 9 bevorzugt gemeinsam mit wenigstens einer weiteren der Gradientenspulen der Magnetresonanzeinrichtung 1 eingesetzt.

Dabei bietet sich zum einen besonders eine Kombination mit der A20-Gradientenspule 8 an, nachdem, wie bereits erwähnt, die A20-Feldverteilung in den X-Y-Ebenen konstant ist, jedoch in Z-Richtung variiert, und die durch die Radialgradientenspule 9 erzeugte radiale Feldverteilung in Z-Richtung im Wesentlichen konstant ist und stark mit dem Abstand von der Mittelachse variiert.

Eine andere vorteilhafte Kombination ergibt sich durch Hinzunahme wenigstens der Z-Gradientenspule der Gradientenanordnung 7, da dann mit der radialen Richtung und der Z-Richtung wenigstens zwei wesentlichen Richtungen eines Zylinderkoordinatensystems abgedeckt sind.

Fig. 2 zeigt einen schematischen Querschnitt durch die Patientenaufnahme 3. Die das Isozentrum kennzeichnende Mitte 14, mithin die Lage der Längsachse der Patientenaufnahme 3, ist ebenso markiert. Ersichtlich ist in diesem ersten Ausführungsbeispiel die Radialgradientenspule 9 unterhalb der im unteren Bereich der Patientenaufnahme 3 angeordneten Patientenliege 4 unter Nutzung eines Gehäuses 15 befestigt. Es ist auch eine gänzliche Integration in die Patientenliege 4 grundsätzlich denkbar.

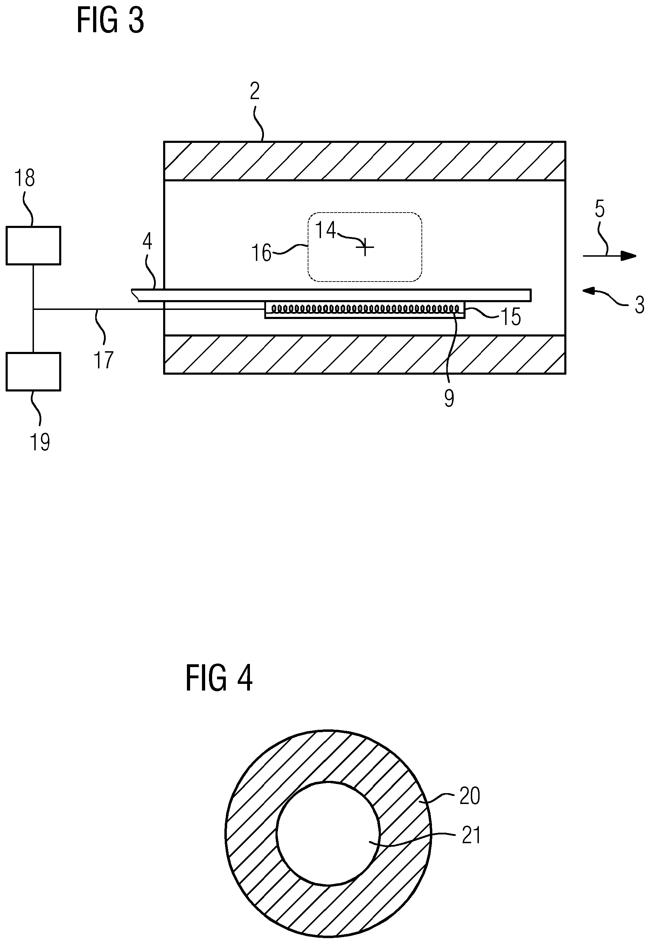

Fig. 3 zeigt den entsprechenden Längsschnitt 3, in dem neben dem Zentrum der Patientenaufnahme 3 auch schematisch das Sichtfeld 16, also das Homogenitätsvolumen, der Magnetresonanzeinrichtung 1 gezeigt ist. Die Länge der unterhalb der Patientenliege 4 befestigten Radialgradientenspule 9 ist ersichtlich größer als die Ausdehnung des Sichtfelds 16 in Längsrichtung 5 gewählt, so dass auch bei Verschiebungen der Patientenliege 4, beispielsweise zur Aufnahme eines anderen Körperbereichs eines Patienten, das von der Radialgradientenspule 9 erzeugte Gradientenfeld zumindest im Wesentlichen radial bleibt.

Gezeigt sind in Fig. 3 auch Zuleitungen 17 zu der Radialgradientenspule 9, welche zum einen die von einem zugeordneten Gradientenverstärker 18 kommenden elektrischen Zuleitungen 17 umfassen, zum anderen aber auch Kühlleitungen für ein Kühlmittel einer Kühleinrichtung 19. Dabei kann als Kühlmittel beispielsweise Öl verwendet werden, um die Magnetresonanzmessung möglichst wenig zu beeinflussen. Im vorliegenden Fall ist jedoch auch die Verwendung von Wasser möglich, da, wie in Fig. 4 genauer gezeigt ist, die Kühleinrichtung 19 einen im Inneren der vorliegend aus Kupfer bestehenden Spulenleiter 20 der Radialgradientenspule 9 realisierten Kühlkanal 21 für das Kühlmedium umfasst.

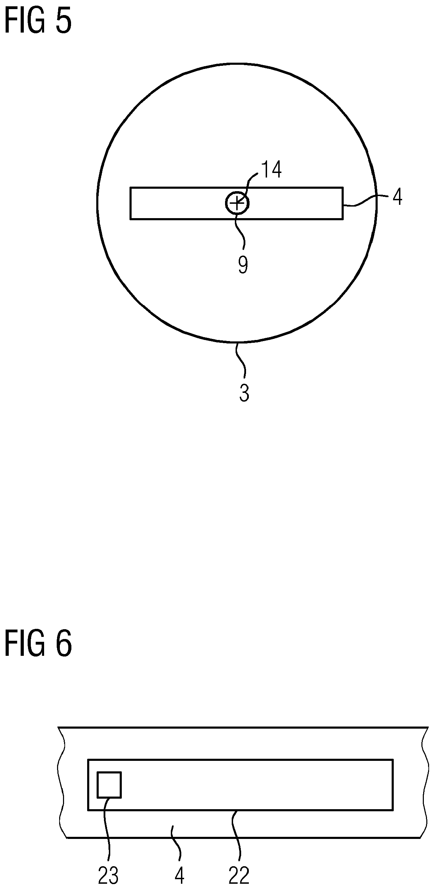

Fig. 5 zeigt einen Querschnitt in einem modifizierten zweiten Ausführungsbeispiel einer erfindungsgemäßen Magnetresonanzeinrichtung 1, wobei die Patientenaufnahme 3 hier einen größeren Durchmesser aufweist, so dass die Patientenliege 4 zentral, vgl. Mittelpunkt 14, innerhalb der Patientenaufnahme 3 verfahren werden kann. Die Radialgradientenspule 9 ist in diesem zweiten Ausführungsbeispiel in die Patientenliege 4 integriert, so dass ihre Mittelachse mit der Längsachse der Patientenaufnahme 3 zusammenfällt.

Fig. 6 zeigt schließlich eine mögliche Ausgestaltung der Patientenliege 4 des zweiten Ausführungsbeispiels. Ersichtlich weist die Patientenliege 4 in diesem Fall eine Radialgradientenspulenaufnahme 22 auf, in die die Radialgradientenspule 9, gegebenenfalls in einem Gehäuse, bei Bedarf eingesetzt werden kann. Ein entsprechender Steckplatz 23 für die Zuleitung 17 ist auch bereits als Teil der Radialgradientenspulenaufnahme 22 vorgesehen.

Selbstverständlich ist auch eine vollständige bzw. dauerhafte Integration der Radialgradientenspule 9 in die Patientenliege 4 denkbar. Weitere Ausführungsbeispiele können auch vorsehen, dass die oder eine weitere Gradientenspule 9 als frei positionierbares Bauteil, vergleichbar der Lokalspule 10, zu realisieren.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, welcher durch die Ansprüche definiert ist.

## Patentansprüche

1. Magnetresonanzeinrichtung (1), aufweisend eine Hauptmagneteinheit (2) mit einer zylindrischen Patientenaufnahme (3), wobei die Magnetresonanzeinrichtung (1) in der Patientenaufnahme (3) wenigstens eine als Zylinderspule ausgebildete Radialgradientenspule (9), die zur Erzeugung eines zumindest bereichsweise einen radialen Gradienten bezüglich der eigenen, zur Längsachse der Patientenaufnahme (3) parallelen Mittelachse aufweisenden Gradientenfeldes ausgebildet ist, aufweist, **dadurch gekennzeichnet, dass** die Magnetresonanzeinrichtung (1) zusätzlich zu der Radialgradientenspule (9) eine A20-Gradientenspule (8) aufweist, und weiter **dadurch gekennzeichnet, dass** eine Steuereinrichtung (13) der Magnetresonanzeinrichtung (1) zur ergänzenden Nutzung der Radialgradientenspule (9) und der A20-Gradientenspule (8) zur Realisierung einer Ortskodierung ausgebildet ist.

2. Magnetresonanzeinrichtung (1) nach Anspruch 1, **dadurch gekennzeichnet, dass** der Windungsradius der Radialgradientenspule (9) in einem Bereich von 1 cm bis 10 cm liegt und/oder sich die Radialgradientenspule (9) in Längsrichtung (5) entlang der Länge eines Homogenitätsvolumens der Magnetresonanzeinrichtung (1) über eine Länge von wenigstens 50 cm erstreckt.

3. Magnetresonanzeinrichtung (1) nach Anspruch 1 oder 2, **dadurch gekennzeichnet, dass** die Mittelachse der Radialgradientenspule (9) der Längsachse der Patientenaufnahme (3) entspricht oder gegen diese verschoben ist, insbesondere in vertikaler Richtung.

4. Magnetresonanzeinrichtung (1) nach einem der vorangehenden Ansprüche, **dadurch gekennzeichnet, dass** die Magnetresonanzeinrichtung (1) zusätzlich zu der Radialgradientenspule (9) und der A20-Gradientenspule (8) eine Gradientenspulenanordnung (7), die Gradientenspulen für Richtungen eines kartesischen Koordinatensystems (6) umfasst, aufweist, wobei die Steuereinrichtung (13) der Magnetresonanzeinrichtung (1) zur ergänzenden Nutzung der Radialgradientenspule (9) und der Gradientenspulenanordnung (7) ausgebildet ist.

5. Magnetresonanzeinrichtung (1) nach einem der vorangehenden Ansprüche, **dadurch gekennzeichnet, dass** sie eine in die Patientenaufnahme (3) einfahrbare Patientenliege (4) aufweist, wobei die Radialgradientenspule (9) in die Patientenliege (4) integriert oder auf oder in der Patientenliege (4), insbesondere unter Verwendung einer Radialgradientenspulenaufnahme (22), platziert oder unterhalb der Patientenliege (4) angeordnet ist.

6. Magnetresonanzeinrichtung (1) nach einem der vorangehenden Ansprüche, **dadurch gekennzeichnet, dass** die Magnetresonanzeinrichtung (1) ein der Radialgradientenspule (9) zugeordnetes Isolationsmittel zur Wärme- und/oder elektrischen Isolation gegenüber einem Patienten umfasst.

7. Magnetresonanzeinrichtung (1) nach einem der vorangehenden Ansprüche, **dadurch gekennzeichnet, dass** die Magnetresonanzeinrichtung (1) eine der Radialgradientenspule (9) zugeordnete Kühleinrichtung (19) umfasst, welche dazu ausgebildet ist, mit einem nicht Wasser entsprechenden Kühlmittel, insbesondere einem Öl, betrieben zu werden und/oder die wenigstens einen innerhalb eines Spulenleiters (20) der Radialgradientenspule (9) verlaufenden Kühlkanal (21) für ein solches Kühlmittel aufweist.

8. Magnetresonanzeinrichtung (1) nach einem der vorangehenden Ansprüche, **dadurch gekennzeichnet, dass** die Magnetresonanzeinrichtung (1) eine zur parallelen Bildgebung ausgebildete Hochfrequenzspulenanordnung (11) aufweist.

9. Verfahren zur Aufnahme von Magnetresonanzdaten mit einer Magnetresonanzeinrichtung (1) nach Anspruch 8, wobei die Hochfrequenzspulenanordnung (11) mehrere Hochfrequenzspulenelemente (12) umfasst, wobei eine parallele Bildgebungstechnik mit der Hochfrequenzspulenanordnung (11) verwendet wird und zur Erzeugung von zur Ortskodierung empfangener Magnetresonanzsignale wenigstens eines Hochfrequenzspulenelements (12) ein mit der Radialgradientenspule (9) erzeugtes Gradientenfeld verwendet wird, wobei zusätzlich zu der Radialgradientenspule (9) zur Ortskodierung auch die A20-Gradientenspule (8) verwendet wird.

10. Verfahren nach Anspruch 9, wobei die Magnetresonanzeinrichtung (1) eine Magnetresonanzeinrichtung (1) nach Anspruch 8, wenn dieser zumindest von Anspruch 4 abhängig ist, ist, **dadurch gekennzeichnet, dass** zusätzlich zu der Radialgradientenspule (9) und der A20-Gradientenspule (8) zur Ortskodierung auch die Gradientenspulenanordnung (7), die Gradientenspulen für Richtungen eines kartesischen Koordinatensystems (6) umfasst, verwendet wird.

11. Verfahren nach Anspruch 10, **dadurch gekennzeichnet, dass** durch gemeinsame Nutzung der Radialgradientenspule (9) und einer einen linearen Gradienten entlang der Längsachse der Patientenaufnahme (3) erzeugenden Gradientenspule der Gradientenspulenanordnung (7) eine Zylinderkoordinaten-Ortskodierung erzeugt wird.

## Claims

1. Magnetic resonance device (1), having a main magnet unit (2) with a cylindrical patient aperture (3), wherein the magnetic resonance device (1) has in the patient aperture (3) at least one radial gradient coil (9), which is embodied as a cylinder coil and is embodied to generate a gradient field having, at least in regions, a radial gradient in relation to its own central axis parallel to the longitudinal axis of the patient aperture (3), **characterised in that** the magnetic resonance device (1) has, in addition to the radial gradient coil (9), an A20 gradient coil (8), and further **characterised in that** a control device (13) of the magnetic resonance device (1) is embodied for supplementary use of the radial gradient coil (9) and the A20 gradient coil (8) in order to realise a spatial encoding.

2. Magnetic resonance device (1) according to claim 1, **characterised in that** the winding radius of the radial gradient coil (9) lies in a range of from 1 cm to 10 cm and/or the radial gradient coil (9) extends in the longitudinal direction (5) along the length of a homogeneity volume of the magnetic resonance device (1) over a length of at least 50 cm.

3. Magnetic resonance device (1) according to claim 1 or 2, **characterised in that** the central axis of the radial gradient coil (9) corresponds to the longitudinal axis of the patient aperture (3) or is displaced in relation thereto, in particular in the vertical direction.

4. Magnetic resonance device (1) according to one of the preceding claims, **characterised in that** the magnetic resonance device (1), in addition to the radial gradient coil (9) and the A20 gradient coil (8), has a gradient coil arrangement (7) that comprises gradient coils for directions of a Cartesian coordinate system (6), wherein the control device (13) of the magnetic resonance device (1) is embodied for supplementary use of the radial gradient coil (9) and the gradient coil arrangement (7).

5. Magnetic resonance device (1) according to one of the preceding claims, **characterised in that** it may have a patient couch (4) which can be moved into the patient aperture (3), wherein the radial gradient coil (9) is integrated into the patient couch (4) or placed on or in the patient couch (4), in particular using a radial gradient coil receptacle (22), or is arranged below the patient couch (4).

6. Magnetic resonance device (1) according to one of the preceding claims, **characterised in that** the magnetic resonance device (1) comprises an insulation means assigned to the radial gradient coil (9) for thermal and/or electrical insulation with respect to a patient.

7. Magnetic resonance device (1) according to one of the preceding claims, **characterised in that** the magnetic resonance device (1) comprises a cooling device (19) assigned to the radial gradient coil (9), which is embodied to be operated with a coolant not corresponding to water, in particular an oil, and/or which has at least one cooling duct (21) for such a coolant running within a coil conductor (20) of the radial gradient coil (9).

8. Magnetic resonance device (1) according to one of the preceding claims, **characterised in that** the magnetic resonance device (1) has a radio-frequency coil arrangement (11) embodied for parallel imaging.

9. Method for recording magnetic resonance data using a magnetic resonance device (1) according to claim 8, wherein the radio-frequency coil arrangement (11) comprises a plurality of radio-frequency coil elements (12), wherein a parallel imaging technique with the radio-frequency coil arrangement (11) is used and a gradient field generated by the radial gradient coil (9) is used to generate magnetic resonance signals of at least one radio-frequency coil element (12) for spatial encoding of received magnetic resonance signals, wherein, in addition to the radial gradient coil (9), the A20 gradient coil (8) is also used.

10. Method according to claim 9, wherein the magnetic resonance device (1) is a magnetic resonance device (1) according to claim 8, where this is dependent upon claim 4, **characterised in that**, in addition to the radial gradient coil (9) and the A20 gradient coil (8), the gradient coil arrangement (7) comprising gradient coils for directions of a Cartesian coordinate system (6) is also used for spatial encoding.

11. Method according to claim 10, **characterised in that** a cylindrical coordinate spatial encoding is generated by the common use of the radial gradient coil (9) and a gradient coil of the gradient coil arrangement (7) generating a linear gradient along the longitudinal axis of the patient aperture (3) .

## Revendications

1. Dispositif (1) à résonnance magnétique comportant une unité (2) magnétique principale ayant un logement (3) cylindrique pour un patient, dans lequel le dispositif (1) à résonnance magnétique a, dans le logement (3) pour le patient, au moins une bobine (9) de gradient radial, qui est constituée sous la forme d'une bobine cylindrique et qui est constituée pour la production d'un champ de gradient ayant, au moins par endroits, un gradient radial par rapport au propre axe médian, parallèle à l'axe longitudinal du logement (3) pour un patient, **caractérisé en ce que** le dispositif (1) à résonnance a, en plus de la bobine (9) de gradient radial, une bobine (8) de gradient A20, et **caractérisé en outre en ce qu'**un dispositif (13) de commande du dispositif (1) à résonnance magnétique est constitué pour l'utilisation complémentaire de la bobine (9) de gradient radial et de la bobine (8) de gradient A20, afin de réaliser un codage d'emplacement.

2. Dispositif (1) à résonnance magnétique suivant la revendication 1, **caractérisé en ce que** le rayon de spire de la bobine (9) de gradient radial est dans une plage de 1 cm à 10 cm et/ou la bobine (9) de gradient radial s'étend dans la direction (5) longitudinale le long de la longueur d'un volume d'homogénéité du dispositif (1) à résonnance magnétique sur une longueur d'au moins 50 cm.

3. Dispositif (1) à résonnance magnétique suivant la revendication 1 ou 2, **caractérisé en ce que** l'axe médian de la bobine (9) de gradient radial correspond à l'axe longitudinal du logement (3) pour le patient ou est décalé par rapport à celui-ci, en particulier dans la direction verticale.

4. Dispositif (1) à résonnance magnétique suivant l'une des revendications précédentes, **caractérisé en ce que** le dispositif (1) à résonnance a, en plus de la bobine (9) de gradient radial et la bobine (8) de gradient A20, un agencement (7) de bobines de gradient, qui comprend des bobines de gradient pour des directions d'un système (6) de coordonnées cartésien, dans lequel le dispositif (13) de commande du dispositif (1) à résonnance magnétique est constitué pour l'utilisation complémentaire de la bobine (9) de gradient radial et de l'agencement (7) de bobines de gradient.

5. Dispositif (1) à résonnance magnétique suivant l'une des revendications précédentes, **caractérisé en ce qu'**il a une couchette (4) de patient pouvant être introduite dans le logement (3) pour le patient, dans lequel la bobine (9) de gradient radial est intégrée à la couchette (4) de patient ou est placée sur ou dans la couchette (4) de patient en utilisant en particulier un logement (22) de bobine de gradient radial, ou est disposée en-dessous de la couchette (4) de patient.

6. Dispositif (1) à résonnance magnétique suivant l'une des revendications précédentes, **caractérisé en ce que** le dispositif (1) à résonnance magnétique comprend un moyen d'isolation, associé à la bobine (9) de gradient radial pour l'isolation calorifique et/ou électrique par rapport à un patient.

7. Dispositif (1) à résonnance magnétique suivant l'une des revendications précédentes, **caractérisé en ce que** le dispositif (1) à résonnance magnétique comprend un dispositif (19) de refroidissement, qui est associé à la bobine (9) de gradient radial et qui est constitué
pour fonctionner avec un fluide de refroidissement correspondant, qui n'est pas de l'eau, en particulier avec une huile,
et/ou qui a au moins un conduit (21) de refroidissement d'un tel fluide de refroidissement s'étendant à l'intérieur d'un conducteur (20) de la bobine (9) de gradient radial.

8. Dispositif (1) à résonnance magnétique suivant l'une des revendications précédentes, **caractérisé en ce que** le dispositif (1) à résonnance magnétique a un agencement (11) de bobine de haute fréquence constitué pour l'imagerie parallèle.

9. Procédé d'enregistrement de données de résonnance magnétique par un dispositif (1) à résonnance magnétique suivant la revendication 8,
dans lequel l'agencement (11) de bobines de haute fréquence comprend plusieurs éléments (12) de bobines de haute fréquence, dans lequel on utilise une technique d'imagerie parallèle avec l'agencement (11) de bobines de haute fréquence et, pour la production de signaux de résonnance magnétique, reçus pour le codage d'emplacement, d'au moins un élément (12) de bobines de haute fréquence, on utilise un champ de gradient produit par la bobine (9) de gradient radial, dans lequel on utilise, en plus de la bobine (9) de gradient radial, pour le codage d'emplacement, également la bobine (8) de gradient A20.

10. Procédé suivant la revendication 9, dans lequel le dispositif (1) à résonnance magnétique est un dispositif (1) à résonnance magnétique suivant la revendication 8, lorsque celle-ci dépend au moins de la revendication 4, **caractérisé en ce que** en plus de la bobine (9) de gradient radial et de la bobine (8) de gradient A20, on utilise, pour le codage d'emplacement, l'agencement (7) de bobines de gradient, qui comprend des bobines de gradient pour des directions d'un système (6) de coordonnées cartésien.

11. Procédé suivant la revendication 10, **caractérisé par** l'utilisation commune de la bobine (9) de gradient radial et d'une bobine de gradient produisant un gradient linéaire le long de l'axe longitudinal du logement (3) pour le patient, de l'agencement (7) de bobines de gradient, on produit un codage d'emplacement en coordonnées cylindriques.
